# FASCICULE DE BREVET EUROPEEN

(11) **EP 1 634 487 B1**
(45) Date de publication et mention de la délivrance du brevet: **16.04.2008**
(21) Numéro de dépôt: 04767295.1
(22) Date de dépôt: 09.06.2004
(51) Int. Cl.: H05K 9/00

(54) **STRUCTURE DE BLINDAGE ELECTROMAGNETIQUE**
ELEKTROMAGNETISCHE ABSCHIRMSTRUKTUR
ELECTROMAGNETIC SHIELD STRUCTURE

(30) Priorité: 13.06.2003 FR 0307122
(43) Date de publication de la demande: 15.03.2006
(73) Titulaire: SAINT-GOBAIN GLASS FRANCE, 92400 Courbevoie (FR)
(72) Inventeur: ZAGDOUN, Georges, F-92250 La Garenne Colombes (FR)
(74) Mandataire: Aupetit, Muriel J. C.
(86) Numéro de dépôt international: PCT/FR2004/001429
(87) Numéro de publication internationale: WO 2005/004574

(56) Documents cités:
- EP-A- 0 930 637
- EP-A- 0 977 167
- EP-A- 1 196 018

## Description

L'invention a pour objet une structure de blindage électromagnétique et concerne plus particulièrement la connexion électrique à la masse de cette structure.

Une structure de blindage électromagnétique est par exemple utilisée dans un écran de visualisation tel qu'un écran plasma.

Un écran plasma comporte un mélange de gaz plasmagène (Ne, Xe, Ar) emprisonné entre deux feuilles de verre, et des luminophores disposés sur la face interne de la feuille arrière de l'écran. Le rayonnement lumineux ultraviolet émis par le mélange de gaz plasmagène lors de la décharge plasma entre les deux feuilles de verre interagit avec les luminophores de la face interne de la feuille arrière pour produire le rayonnement lumineux visible (rouge, vert, bleu). Un mécanisme de désexcitation des particules de gaz rentre en compétition avec l'émission U.V., ce qui engendre un rayonnement infrarouge entre 800 et 1250 nm dont la propagation, principalement au travers de la face avant de l'écran, peut être à l'origine de perturbations très gênantes, notamment pour les équipements situés à proximités et commandés par infra-rouge, par exemple au moyen de télécommandes.

Par ailleurs, comme tous les appareils électroniques, les écrans plasma possèdent des systèmes d'adressage (drivers) qui peuvent générer un rayonnement parasite vis-à-vis d'autres dispositifs avec lesquels ils ne doivent pas interférer tels que microordinateurs, téléphones portables...

Afin d'annihiler, et pour le moins réduire, la propagation de ces rayonnements, une solution consiste à disposer contre la face avant de l'écran de visualisation une structure à la fois transparente et métallisée pour assurer un blindage électromagnétique.

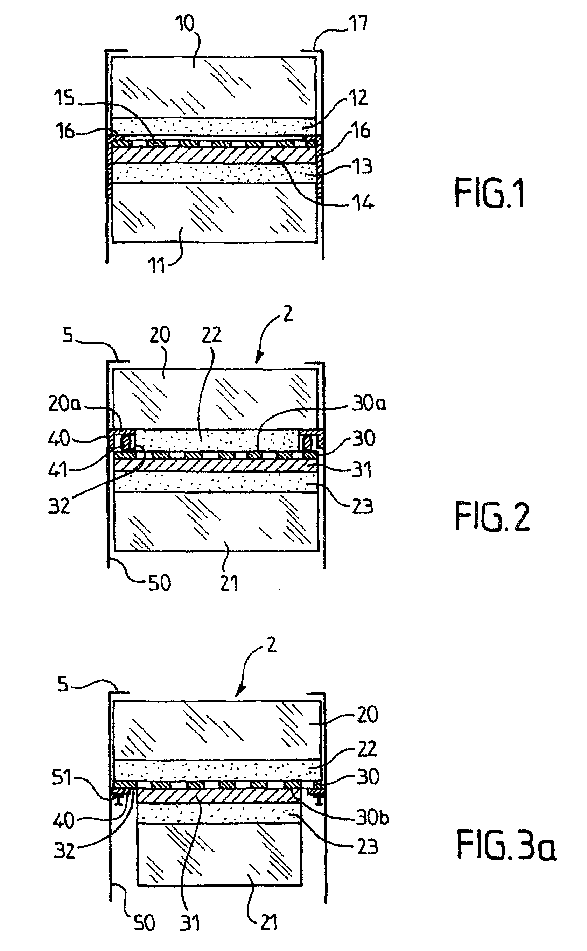

Un exemple de structure de blindage connu tel qu'illustré sur la figure 1 comporte deux substrats en verre 10 et 11 entre lesquels sont feuilletées deux feuilles de matière thermoplastique en PVB 12 et 13 et une feuille en PET 14 sur laquelle est déposée par photolitographie une grille en cuivre 15 constituant l'élément conducteur de blindage électromagnétique de la structure, la feuille en PET 14 étant feuilletée entre les deux feuilles de PVB 12 et 13. La connexion électrique de la grille en cuivre à la masse est réalisée à l'aide de conducteurs plats tels des bus-bar 16 soudés d'une part à la grille de cuivre 15, et reliés d'autre part à un cadre métallique 17 relié à la masse. Ce cadre métallique constitue le cadre de l'écran de visualisation et sert de support à la structure de blindage associée à l'écran.

Pour maintenir en position les conducteurs plats 16 en vue de leur soudage sur l'une des faces de la grille en cuivre 15, les conducteurs forment un retour sur la tranche de la feuille en PET 14, le soudage a lieu lors de l'assemblage de la feuille en PET et des feuilles en PVB par chauffage des matières thermoplastiques.

Cependant une mauvaise manipulation des feuilles de PVB et/ou une mauvaise opération d'assemblage des feuilles de PVB et de la feuille de PET comportant les conducteurs peuvent engendrer des défauts dans la structure tels que des cloques entre les feuilles de matière plastique. De tels défauts sont visibles à l'oeil nu et un tel produit ne peut alors pas être utilisé dans des écrans de visualisation.

De plus, rabattre et coller de manière propre et sans défauts les conducteurs plats sur la tranche de la feuille en PET pour former les retours n'est pas une étape rapide dans un procédé de fabrication industriel. Et si ce pliage est mal réalisé, il peut conduire à une coupure en coin des retours.

Par conséquent, la dépendance de manière solidaire des moyens de connexion électrique, constitués par les conducteurs plats, à l'élément conducteur de blindage et à la feuille de PET support de l'élément conducteur de blindage ne permet pas une facilité de fabrication de la structure de blindage.

D'autres agencements d'éléments d'une structure de blindage électromagnétique sont également connus et décrits par exemple dans le document EP-A-1196018.

L'invention a donc pour but de pallier à ces inconvénients en proposant une structure de blindage électromagnétique qui autorise une connexion plus simple de l'élément conducteur de la structure à la masse électrique, par exemple de l'écran auquel elle est associée.

Selon un premier mode de réalisation de l'invention, la structure de blindage électromagnétique présente les caractéristiques de la revendication 1.

On nomme faces de l'élément conducteur, les surfaces s'étendant selon les plus grandes dimensions.

Selon ce premier mode de réalisation, la structure est caractérisée en ce que la feuille de liaison agencée en retrait par rapport au bord libre associé du substrat transparent laisse place à une partie libre du substrat transparent, cette partie libre étant en regard de la portion dégagée de l'élément conducteur, et que les moyens de connexion sont rendus solidaires par collage de la partie libre du substrat, et sont reliés à la portion dégagée de l'élément conducteur disposée en regard de la partie libre par des moyens de liaison électrique.

Selon un second mode de réalisation de l'invention, la structure de blindage électromagnétique présente les caractéristiques de la revendication 3.

Selon ce deuxième mode de réalisation, la structure est caractérisée en ce que les moyens de connexion sont rendus solidaires par collage et/ou par serrage mécanique à la portion dégagée de l'élément conducteur.

Selon une caractéristique, l'élément conducteur est une couche métallique à base d'argent. En variante, l'élément conducteur est constitué d'une grille de fils conducteurs, de préférence en cuivre.

Selon une autre caractéristique, les moyens de connexion sont constitués d'un conducteur plat tel qu'un bus-bar ou un ruban de mousse conductrice.

Avantageusement, l'ensemble de la périphérie du premier substrat de la face située vers l'intérieur de la structure ou bien la partie libre dudit premier substrat est recouverte d'un émail.

De préférence, la portion dégagée correspond à la manière d'un cadre, à l'ensemble de la périphérie de l'une des faces de l'élément conducteur.

Selon une autre caractéristique, la feuille de support est en matière plastique, par exemple en PET ou à base de l'une des matières suivantes, polycarbonate, polyméthyl(métha)acrylate, polyether sulfone, polyetherketone, et acyronitrile-styrène copolymère. Par ailleurs, la feuille de liaison, la feuille supplémentaire sont en matière plastique, telle qu'en polyvinylbutyral, ou en polyuréthanne, ou en ethylène-vinyl-acétate.

Dans son utilisation, la structure est par exemple encastrée dans un cadre dont la partie intérieure est métallique et contre laquelle courent les moyens de connexion.

Enfin, la structure peut être assemblée à la face avant d'un écran de visualisation, tel qu'un écran plasma, et reliée à la masse électrique de cet écran.

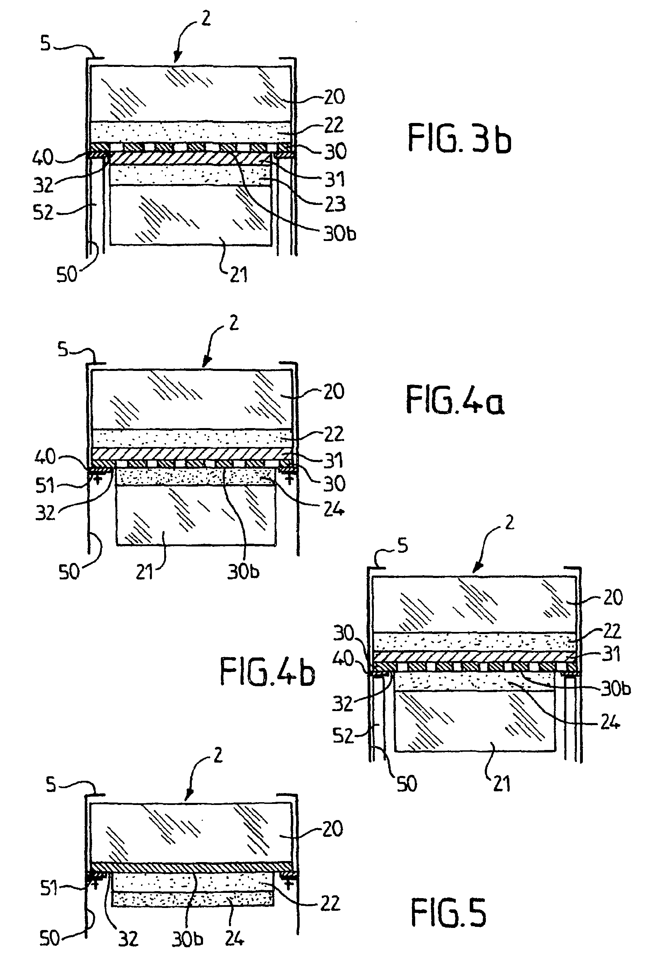

D'autres avantages et caractéristiques de l'invention vont à présent être décrits plus en détail en regard des dessins annexés sur lesquels :
● La figure 1 est une vue en coupe d'une structure de blindage électromagnétique pour un écran de visualisation selon l'art antérieur;
● Les figures 2, et 3a, 3b sont des vues en coupe d'une structure de blindage électromagnétique selon respectivement deux modes de réalisation de l'invention.
● Les figures 4a, 4b et 5 sont des vues en coupe de structures de blindage non-conformes à l'invention mais utiles à la compréhension de l'invention.

Sur les figures 2, 3a, 3b, 4a, 4b et 5 sont illustrés à titre d'exemples non limitatifs quatre modes de réalisation d'une structure de blindage électromagnétique 2 destinée par exemple à être associée à la face avant d'un écran de visualisation, ici non illustré, tel qu'un écran plasma. Seul est représenté partiellement le cadre 5 de l'écran dans lequel est encastrée la structure de blindage 2. L'invention réalise la connexion électrique de la structure de blindage à la masse électrique de l'écran.

Pour plus de détails sur les modes de réalisation de la structure de blindage et leurs variantes, on se référera à la demande de brevet français FR 03/04636.

La structure de blindage 2 comporte au moins un premier substrat transparent 20 de type verrier de préférence, éventuellement un second substrat transparent 21 de type verrier, et un élément conducteur 30 de blindage électromagnétique associé au premier substrat. Des moyens de connexion électrique 40 sont rapportés et sont destinés à relier électriquement l'élément conducteur 30 à une partie conductrice 50 de l'écran, telle que l'intérieur métallique du cadre 5 supportant la structure de blindage pour son association à l'écran, la partie intérieure métallique 50 étant destinée à être reliée à la masse de l'écran.

La structure de blindage 2 est ainsi disposée dans le cadre 5 destiné à être associé à l'écran par des moyens usuels de fixation mécanique. Le premier substrat verrier 20 est destiné à être face au spectateur, qu'on définira dans la suite de la description comme le côté avant de la structure, tandis que le second substrat 21 est destiné à être en regard de l'écran, c'est-à-dire du côté arrière de la structure.

Avantageusement, le premier substrat 20 est en verre trempé pour résister à des chocs, et présente sur sa face externe du côté du spectateur une couche anti-reflets.

L'élément conducteur 30 est par exemple constitué d'une grille de fils métalliques, avantageusement en cuivre, déposée sur une feuille de support 31 transparente en matière plastique, par exemple en PET ou à base de l'une des matières suivantes, polycarbonate, polyméthyl(métha)acrylate, polyether sulfone, polyetherketone, et acyronitrile-styrène copolymère.

En variante, l'élément conducteur 30 peut être plutôt une couche métallique, telle qu'à base d'argent, déposée sur la feuille de support 31 en matière plastique ou bien déposée directement sur la face interne du substrat 20 vers l'intérieur de la structure.

La structure 2 comporte également une feuille de liaison 22 transparente en matière plastique, telle qu'en polyvinylbutyral, ou en polyuréthanne, ou en ethylène-vinyl-acétate, disposée contre le premier substrat 20.

La feuille de liaison 22 assure, lorsque l'élément conducteur 30 est rapporté sur la feuille de support 31, l'association de l'élément conducteur au premier substrat 20 par l'assemblage de la feuille de support 31 de l'élément conducteur à ladite feuille de liaison 22 après chauffage des matières plastiques.

Lorsque l'élément conducteur 30 est déposé directement sur le substrat 20, la feuille de liaison 22 assure notamment l'association du substrat à tout autre élément.

Contrairement à l'art antérieur pour lequel la connexion électrique de l'élément conducteur de blindage est réalisée par des conducteurs plats qui dépendent et recouvrent les tranches de l'élément conducteur et de la feuille de support (figure 1), la connexion selon l'invention est obtenue comme il va être expliqué, directement sur l'une des faces de l'élément conducteur et en y rapportant les moyens de connexion après fabrication de la structure.

Dans le mode de réalisation illustrée sur la figure 2, la feuille de liaison 22 ne s'étend pas jusqu'aux bords du premier substrat verrier 20 mais est en retrait vers l'intérieur de la structure de manière à laisser place à un partie libre 20a, avantageusement sur l'ensemble de la périphérie interne du substrat verrier, cette partie libre du substrat étant de préférence recouverte d'un émail de couleur noir.

Les moyens de connexion 40 sont fixés sur cette partie libre 20a et s'étendent sur la partie conductrice intérieure 50 du cadre 5. Les moyens de connexion 40 consistent par exemple en un bus-bar, fixé par collage par exemple, sur cette partie libre 20a de la périphérie du substrat verrier, l'émail noir cachant la vision depuis l'extérieur de ces moyens de connexion.

Quant à l'élément conducteur 30 positionné sur la feuille de support 31 et en regard de la feuille de liaison 22, il s'étend au-delà de la feuille de liaison 22 de manière qu'une portion 32 de sa face 30a en regard de la feuille de liaison 22 soit positionnée en regard de la partie libre 20a sur laquelle sont fixés les moyens de connexion 40. La portion 32 correspond de préférence à l'ensemble de la périphérie de l'une des faces, ici la face 30a, de l'élément conducteur. La liaison électrique entre les moyens de connexion 40 et la portion 32 de l'élément conducteur en regard des moyens de connexion est assurée par tous moyens de liaison électrique adaptés 41, par exemple une couche de colle conductrice ou un ruban adhésif conducteur du type en cuivre.

Dans ce mode de réalisation, la structure comporte le second substrat verrier 21 qui présente des dimensions équivalentes à la feuille de support 31. Il est associé à la feuille de support grâce à une feuille supplémentaire 23 en matière plastique telle que du PVB de dimensions équivalentes à celles de la feuille de support 31 et du substrat verrier 21.

En variante mais non illustré, la structure peut ne pas comporter de second substrat verrier, et la feuille de support 31 constitue alors directement la face arrière qui est destinée à être associée à l'écran.

Dans la second mode de réalisation illustré sur les figures 3a et 3b pour lequel l'élément conducteur 30 reste feuilleté entre la feuille de support 31 et la feuille de liaison 22, il n'est pas nécessaire que la feuille de liaison 22 soit diminuée en superficie par rapport au premier substrat verrier. Par contre, la feuille de support 31 est en retrait par rapport à l'élément conducteur de manière à laisser dépasser une portion 32 de sa face 30b, face associée à la feuille de support 31. Cette portion 32, qui correspond de préférence à l'ensemble de la périphérie de la face 30b, est alors directement accessible depuis l'arrière de la structure pour recevoir par application et par pression mécanique les moyens de connexion 40.

Les moyens de connexion 40 peuvent par exemple être constitués d'un bus-bar. Ce bus-bar est par exemple plaqué contre la portion 32 de la face 30b de l'élément conducteur par le serrage d'une patte métallique 51 solidaire du cadre 5 de mise à la masse électrique (figure 3a), ou bien être pressé contre la portion 32 par une partie 52 du cadre de l'écran qui vient s'insérer entre la structure et la partie conductrice 50 du cadre (figure 3b). Le serrage mécanique des moyens de connexion 40 est en fait réalisé par tous moyens adaptés et à portée de l'homme de l'art.

En variante, les moyens de connexion 40 peuvent être constitués d'une mousse conductrice qui est adhésive pour être rendue solidaire de la portion 32 de l'élément conducteur et de la partie conductrice 50 du cadre, cette mousse étant déposée par une technique d'extrusion ou d'injection.

Dans ce second mode de réalisation, le second substrat verrier 21 qui est rendu solidaire de la feuille de support 31 grâce à une feuille supplémentaire 23 en matière plastique telle que du PVB est aux dimensions de la feuille supplémentaire et de la feuille de support.

En variante mais non illustré et comme dans le premier mode de réalisation, la structure peut ne pas comporter de second substrat verrier 21, et la feuille de support 31 constitue alors directement la face arrière qui est destinée à être associée à l'écran.

Dans un mode de réalisation non-conforme à l'invention (figures 4a et 4b), l'élément conducteur 30 est disposé, non pas en feuilleté entre la feuille de liaison 22 et la feuille de support 31, mais à l'opposé de la feuille de liaison 22. Dans ce cas, la structure 1 comporte en outre une feuille de recouvrement 24 transparente en matière plastique, telle qu'en PVB. Cette feuille de recouvrement 24 est déposée contre l'élément conducteur 30 de manière à former une couche de protection. Elle permet de plus l'association de l'élément conducteur 30 au second substrat 21 par l'assemblage de ladite feuille de recouvrement audit substrat.

Cette disposition de l'élément conducteur 30 placé du côté arrière de la structure et donc à l'opposé du spectateur engendre un emplacement de la feuille de support 31 en PET du côté du spectateur. Lorsque l'élément conducteur est une grille en cuivre, l'interface de collage entre la grille et le PET présente de manière connue un pigment noir qui se trouve alors du côté du spectateur. Cette configuration présente alors l'avantage d'atténuer le reflet rouge du cuivre de l'élément conducteur, le confort visuel du spectateur étant encore amélioré.

Dans ce mode de réalisation, les feuilles de liaison 22 et de support 31 n'ont pas besoin d'être en retrait par rapport au premier substrat 20, et peuvent être de dimensions équivalentes au premier substrat. L'élément conducteur 30 s'étend également sur l'ensemble de la superficie de la feuille de support 31, et donc jusqu'aux bords du substrat 20. Par contre, la feuille de recouvrement 24 est de dimensions inférieures, et en retrait vers l'intérieur de la structure de manière à laisser accessible une portion 32, de préférence sur l'ensemble de la périphérie, de la face 30a opposée à la feuille de support 31. Le second substrat verrier 21 qui est rendu solidaire de la feuille de recouvrement 24 est aux dimensions de ladite feuille.

De manière similaire au deuxième mode de réalisation de l'invention, les moyens de connexion 40 sont agencés directement par l'arrière contre la portion 32 de la face 30b de l'élément conducteur. Les variantes de réalisation des moyens de connexion 40 et de leur application sont aussi celles décrites dans le second mode de réalisation.

Dans un mode de réalisation non-conforme à l'invention mais utile à la compréhension de l'invention (figure 5), l'élément conducteur 30 est déposé sur la face interne du premier substrat 20, vers l'intérieur de la structure, l'élément conducteur se présentant sous forme de couche métallique, telle qu'à base d'argent. La structure comporte une feuille de liaison 22 qui peut assurer l'assemblage du premier substrat 20 avec le second substrat verrier s'il est présent (ici non illustré) ou l'assemblage direct avec l'écran. La structure peut éventuellement comporter une feuille de recouvrement 24 en matière plastique telle qu'en PVB qui permet d'assurer une autre fonction que la fonction remplie par la feuille de liaison 22, ou de protéger la feuille de liaison 22 si celle-ci est faite d'une matière qui peut être facilement rayée par exemple et de constituer alors une feuille d'assemblage de la structure avec le second substrat verrier s'il est présent (ici non illustré sur la figure 5) ou bien une feuille d'assemblage de la structure directement avec l'écran.

Dans ce mode de réalisation, les feuilles 22 et 24 sont en retrait vers l'intérieur de la structure de manière à laisser accessible une portion dégagée 32, de préférence sur l'ensemble de la périphérie, de la face 30b de l'élément conducteur.

Les moyens de connexion 40 sont également agencés directement par l'arrière contre la portion 32 de la face 30b de l'élément conducteur. Les variantes de réalisation des moyens de connexion 40 et de leur application sont aussi celles décrites dans le second mode de réalisation, ici étant illustrées les pattes de serrage mécanique 51.

A noter que comme dans le premier mode de réalisation, le substrat 20 du deuxième mode de réalisation est recouvert, sur l'ensemble de sa périphérie et sur sa face interne vers l'intérieur de la structure, d'un émail noir qui permet de cacher l'ensemble de la connexion électrique.

Ainsi, selon l'invention, l'une au moins de la feuille de support 31 de l'élément conducteur, de la feuille de liaison 22, et de la feuille supplémentaire 23 lorsque l'une est présente, est sur au moins l'un de ses côtés, agencée en retrait vers l'intérieur de la structure par rapport au bord libre associé du premier substrat 20 de manière à laisser nue ou dégagée sur au moins l'une de ses faces 30a ou 30b, une portion 32 de l'élément conducteur. Les moyens de connexion 40 reliant l'élément conducteur 30 à la masse électrique de l'écran sont avantageusement un conducteur plat tel qu'un bus-bar ou un ruban de mousse conductrice qui est relié à la portion dégagée 32 de l'une des faces 30a ou 30b de l'élément conducteur 30 par collage ou par serrage mécanique.

Les moyens de connexion 40 sont ainsi rendus indépendants de l'élément conducteur 30, la structure de blindage n'ayant pas besoin de comprendre intrinsèquement les moyens de connexion électrique, ce qui permet de faciliter la fabrication des structure de blindage et des écrans.

## Revendications

1. Structure de blindage électromagnétique comportant au moins un premier substrat transparent (20), un élément conducteur (30) déposé sur une feuille de support transparente (31) en matière plastique, ainsi qu'une feuille de liaison transparente (22) en matière plastique qui assure l'association de l'élément conducteur (30) au substrat (20) par l'assemblage de la feuille de support (31) à la feuille de liaison (22) du côté de l'élément conducteur, une feuille supplémentaire (23) transparente associée à la feuille de support (31) contre la face opposée à la face associée à la feuille de liaison (22) , des moyens de connexion électrique (40) étant destinés à être reliés à l'élément conducteur (30) pour la mise à la masse de ce dernier, **caractérisée en ce que** la feuille de liaison (22), est, sur au moins l'un de ses côtés, agencée en retrait vers l'intérieur de la structure par rapport au bord libre associé du substrat transparent (20) de manière à laisser dégagée sur au moins l'une des faces (30a,30b) de l'élément conducteur une portion (32), les moyens de connexion (40) étant rapportés contre, et/ou reliés, à cette portion dégagée (32).

2. Structure selon la revendication 1 **caractérisée en ce que** la feuille de liaison (22) agencée en retrait par rapport au bord libre associé du substrat transparent (20) laisse place à une partie libre (20a) du substrat transparent , cette partie libre (20a) étant en regard de la portion dégagée (32) de l'élément conducteur, et que les moyens de connexion (40) sont rendus solidaires par collage de la partie libre (20a) du substrat, et sont reliés à la portion dégagée (32) de l'élément conducteur disposée en regard de la partie libre (20a) par des moyens de liaison électrique (41).

3. Structure de blindage électromagnétique comportant au moins un premier substrat transparent (20), un élément conducteur (30) déposé sur une feuille de support transparente (31) en matière plastique, une feuille de liaison transparente (22) en matière plastique qui assure l'association de l'élément conducteur (30) au substrat (20) par l'assemblage de la feuille de support (31) à la feuille de liaison (22) du côté de l'élément conducteur, et une feuille supplémentaire (23) transparente associée à la feuille de support (31) contre la face opposée à la face associée à la feuille de liaison (22), des moyens de connexion électrique (40) étant destinés à être reliés à l'élément conducteur (30) pour la mise à la masse de ce dernier, **caractérisé en ce que** la feuille de support (31) et la feuille supplémentaire (23) sont, sur au moins l'un de leurs côtés, agencées en retrait vers l'intérieur de la structure par rapport au bord libre associé du substrat transparent (20) de manière à laisser dégagée sur au moins l'une des faces (30a, 30b) de l'élément conducteur une portion 32), les moyens de connexion (40) étant rapportés contre, et/ou reliés, à cette portion dégagée.

4. Structure selon la revendication 3, **caractérisée en ce que** les moyens de connexion (40) sont rendus solidaires par collage et/ou par serrage mécanique à la portion dégagée (32) de l'élément conducteur.

5. Structure selon l'une quelconque des revendications précédentes, **caractérisée en ce que** l'élément conducteur (30) est une couche métallique à base d'argent.

6. Structure selon l'une quelconque des revendications 1 à 4, **caractérisée en ce que** l'élément conducteur (30) est constitué d'une grille de fils conducteurs, de préférence en cuivre.

7. Structure selon l'une quelconque des revendications précédentes, **caractérisée en ce que** les moyens de connexion (40) sont constitués d'un conducteur plat tel qu'un bus-bar ou un ruban de mousse conductrice.

8. Structure selon l'une quelconque des revendications précédentes, **caractérisée en ce que** l'ensemble de la périphérie du premier substrat (20) de la face située vers l'intérieur de la structure ou bien la partie libre (20a) dudit premier substrat est recouverte d'un émail.

9. Structure selon l'une quelconque des revendications précédentes, **caractérisée en ce que** la portion dégagée (32) correspond à la manière d'un cadre, à l'ensemble de la périphérie de l'une des faces (30, 30b) de l'élément conducteur.

10. Structure selon l'une quelconque des revendications précédentes, **caractérisée en ce que** la feuille de support (31) est en matière plastique, par exemple en PET ou à base de l'une des matières suivantes, polycarbonate, polyméthyl(métha)acrylate, polyether sulfone, polyetherketone, et acyronitrile-styrène copolymère.

11. Structure selon l'une quelconque des revendications précédentes, **caractérisée en ce que** la feuille de liaison (22), la feuille supplémentaire (23) sont en matière plastique, telle qu'en polyvinylbutyral, ou en polyuréthanne, ou en ethylène-vinyl-acétate.

12. Structure selon l'une quelconque des revendications précédentes, **caractérisée en ce qu'**elle est encastrée dans un cadre (5) dont la partie intérieure (50) est métallique et contre laquelle courent les moyens de connexion (40).

13. Structure selon l'une quelconque des revendications précédentes, **caractérisée en ce qu'**elle est assemblée à la face avant d'un écran de visualisation, tel qu'un écran plasma, et reliée à la masse électrique de cet écran.

## Claims

1. Electromagnetic screening structure comprising at least a first transparent substrate (20), a conducting element (30) deposited on a transparent plastic backing sheet (31), and a transparent plastic tie sheet (22) that ties the conducting element (30) to the substrate (20) by the backing sheet (31) being joined to the tie sheet (22) on the conducting element side, a transparent additional sheet (23) joined to the backing sheet (31) against the opposite face to the face joined to the tie sheet (22), electrical connection means (40) being intended to be connected to the conducting element (30) in order to ground the latter, **characterized in that** the tie sheet (22) is, at least on one of its sides, placed set back towards the interior of the structure relative to the associated free edge of the transparent substrate (20) so as to leave a portion (32) exposed on at least one of the faces (30a, 30b) of the conducting element, the connection means (40) being placed against and/or connected to this exposed portion (32).

2. Structure according to Claim 1, **characterized in that** the tie sheet (22) placed set back relative to the associated free edge of the transparent substrate (20) leaves space for a free part (20a) of the transparent substrate, this free part (20a) facing the exposed portion (32) of the conducting element, and **in that** the connection means (40) are fastened by adhesive bonding to the free part (20a) of the substrate and are connected via electrical bonding means (41) to that exposed portion (32) of the conducting element facing the free part (20a).

3. Electromagnetic screening structure comprising at least a first transparent substrate (20), a conducting element (30) deposited on a transparent plastic backing sheet (31), a transparent plastic tie sheet (22) that ties the conducting element (30) to the substrate (20) by the backing sheet (31) being joined to the tie sheet (22) on the conducting element side, and a transparent additional sheet (23) joined to the backing sheet (31) against the opposite face to the face joined to the tie sheet (22), electrical connection means (40) being intended to be connected to the conducting element (30) in order to ground the latter, **characterized in that** the backing sheet (31) and the additional sheet (23) are, at least on one of their sides, placed set back towards the interior of the structure relative to the associated free edge of the transparent substrate (20) so as to leave a portion (32) exposed on at least one of the faces (30a, 30b) of the conducting element, the connection means (40) being placed against and/or connected to this exposed portion.

4. Structure according to Claim 3, **characterized in that** the connection means (40) are fastened by adhesive bonding and/or by mechanical crimping to the exposed portion (32) of the conducting element.

5. Structure according to any one of the preceding claims, **characterized in that** the conducting element (30) is a silver-based metal layer.

6. Structure according to any one of Claims 1 to 4, **characterized in that** the conducting element (30) consists of a mesh of conducting wires, preferably copper wires.

7. Structure according to any one of the preceding claims, **characterized in that** the connection means (40) consist of a flat conductor such as a busbar or a conductive foam tape.

8. Structure according to any one of the preceding claims, **characterized in that** all of the periphery of the first substrate (20) of the face situated towards the interior of the structure or else the free part (20a) of said first substrate is covered with an enamel.

9. Structure according to any one of the preceding claims, **characterized in that** the exposed portion (32) corresponds, in the manner of a frame, to the entire periphery of one of the faces (30, 30b) of the conducting element.

10. Structure according to any one of the preceding claims, **characterized in that** the backing sheet (31) is made of a plastic, for example PET or one based on one of the following materials: polycarbonate, polymethyl (meth)acrylate, polyethersulphone, polyether- ketone and styrene-acrylonitrile copolymers.

11. Structure according to any one of the preceding claims, **characterized in that** the tie sheet (22) and the additional sheet (23) are made of a plastic, such as polyvinyl butyral, polyurethane or ethylene-vinyl acetate.

12. Structure according to any one of the preceding claims, **characterized in that** it is fitted into a frame (5), the inner part (50) of which is metallic, the connection means (40) pressing against said inner part.

13. Structure according to any one of the preceding claims, **characterized in that** it is joined to the faceplate of a display, such as a plasma display, and connected to the electrical ground of this display.

## Patentansprüche

1. Elektromagnetisch abschirmender Aufbau, der mindestens ein erstes transparentes Substrat (20), ein leitfähiges Element (30), das auf einer transparenten Tragfolie (31) aus Kunststoff aufgebracht ist, sowie eine transparente Verbindungsfolie (22) aus Kunststoff, die die Verbindung des leitfähigen Elements (30) mit dem Substrat (20) durch Assemblierung der Tragfolie (31) mit der Verbindungsfolie (22) auf der Seite des leitfähigen Elements sicherstellt, eine transparente Zusatzfolie (23), die mit der Tragfolie (31) auf der Seite, die der mit der Verbindungsfolie (22) verbundenen Seite abgewandt ist, verbunden ist, und elektrische Anschlussmittel (40), die vorgesehen sind, mit dem leitfähigen Element (30) verbunden zu werden, um dieses an die Masse anzuschließen, umfasst, **dadurch gekennzeichnet, dass** die Verbindungsfolie (22) auf wenigstens einer ihrer Seiten zum Inneren des Aufbaus in Bezug auf den dem transparenten Substrat (20) zugehörigen freien Rand derart zurückgesetzt angeordnet ist, dass auf wenigstens einer der Seiten (30a, 30b) des leitfähigen Elements ein Teil (32) frei bleibt, wobei die Anschlussmittel (40) an diesen frei gebliebenen Teil (32) angesetzt und/oder mit diesem verbunden sind.

2. Aufbau nach Anspruch 1, **dadurch gekennzeichnet, dass** die Verbindungsfolie (22), die in Bezug auf den dem transparenten Substrat (20) zugehörigen freien Rand zurückgesetzt angeordnet ist, für einen freien Bereich (20a) des transparenten Substrats Platz lässt, wobei dieser freie Bereich (20a) dem frei gebliebenen Teil (32) des leitfähigen Elements zugewandt ist, **und dass** die Anschlussmittel (40) durch eine Klebverbindung mit dem freien Bereich (20a) des Substrats fest verbunden und mit dem frei gebliebenen Teil (32) des leitfähigen Elements, der dem freien Bereich (20a) zugewandt angeordnet ist, durch elektrische Verbindungsmittel (41) verbunden sind.

3. Elektromagnetisch abschirmender Aufbau, der mindestens ein erstes transparentes Substrat (20), ein leitfähiges Element (30), das auf einer transparenten Tragfolie (31) aus Kunststoff aufgebracht ist, eine transparente Verbindungsfolie (22) aus Kunststoff, die die Verbindung des leitfähigen Elements (30) mit dem Substrat (20) durch Assemblierung der Tragfolie (31) mit der Verbindungsfolie (22) auf der Seite des leitfähigen Elements sicherstellt, eine transparente Zusatzfolie (23), die mit der Tragfolie (31) auf der Seite, die der mit der Verbindungsfolie (22) verbundenen Seite abgewandt ist, verbunden ist, und elektrische Anschlussmittel (40), die vorgesehen sind, mit dem leitfähigen Element (30) verbunden zu werden, um dieses an die Masse anzuschließen, umfasst, **dadurch gekennzeichnet, dass** die Tragfolie (31) und die Zusatzfolie (23) auf wenigstens einer ihrer Seiten zum Inneren des Aufbaus in Bezug auf den dem transparenten Substrat (20) zugehörigen freien Rand derart zurückgesetzt angeordnet sind, dass auf wenigstens einer der Seiten (30a, 30b) des leitfähigen Elements ein Teil (32) frei bleibt, wobei die Anschlussmittel (40) an diesen frei gebliebenen Teil angesetzt und/oder mit diesem verbunden sind.

4. Aufbau nach Anspruch 3, **dadurch gekennzeichnet, dass** die Anschlussmittel (40) durch eine Klebverbindung und/oder mechanisches Festklemmen mit dem frei gebliebenen Teil (32) des leitfähigen Elements fest verbunden sind.

5. Aufbau nach einem der vorhergehenden Ansprüche, **dadurch gekennzeichnet, dass** das leitfähige Element (30) eine Metallschicht auf Silberbasis ist.

6. Aufbau nach einem der Ansprüche 1 bis 4, **dadurch gekennzeichnet, dass** das leitfähige Element (30) von einem Gitter aus vorzugsweise aus Kupfer bestehenden leitfähigen Drähten gebildet wird.

7. Aufbau nach einem der vorhergehenden Ansprüche, **dadurch gekennzeichnet, dass** die Anschlussmittel (40) von einem flachen Leiter wie einem bus-bar oder einem leitfähigen Schaumstoffband gebildet werden.

8. Aufbau nach einem der vorhergehenden Ansprüche, **dadurch gekennzeichnet, dass** der gesamte Umfang des ersten Substrats (20) auf der zum Inneren des Aufbaus zeigenden Seite oder der freie Bereich (20a) dieses ersten Substrats mit einem Email beschichtet ist.

9. Aufbau nach einem der vorhergehenden Ansprüche, **dadurch gekennzeichnet, dass** der frei gebliebene Teil (32) wie ein Rahmen dem gesamten Umfang einer der Seiten (30, 30b) des leitfähigen Elements entspricht.

10. Aufbau nach einem der vorhergehenden Ansprüche, **dadurch gekennzeichnet, dass** die Tragfolie (31) aus einem Kunststoff, beispielsweise PET, besteht oder auf der Basis eines der folgenden Materialien ist: Polycarbonat, Polymethylmethacrylat, Polyethersulfon, Polyetherketon und Acyronitril-StyrolCopolymer.

11. Aufbau nach einem der vorhergehenden Ansprüche, **dadurch gekennzeichnet, dass** die Verbindungsfolie (22) und die Zusatzfolie (23) aus einem Kunststoff wie Polyvinylbutyral, Polyurethan oder Ethylen-Vinylacetat bestehen.

12. Aufbau nach einem der vorhergehenden Ansprüche, **dadurch gekennzeichnet, dass** er in einen Rahmen (5) eingefügt ist, dessen Innenteil (50), zu welchem die Anschlussmittel (40) führen, metallisch ist.

13. Aufbau nach einem der vorhergehenden Ansprüche, **dadurch gekennzeichnet, dass** er mit der Vorderseite eines Bildschirms wie eines Plasmabildschirms verbunden und an die elektrische Masse dieses Bildschirms angeschlossen ist.
